(19) Europäisches Patentamt

European Patent Office

Office européen des brevets

(11) **EP 1 696 241 A1**

(12) **EUROPEAN PATENT APPLICATION**
published in accordance with Art. 158(3) EPC

(43) Date of publication:
**30.08.2006 Bulletin 2006/35**

(51) Int Cl.:
***G01R 1/06*** (2006.01)

(21) Application number: **04806923.1**

(22) Date of filing: **13.12.2004**

(86) International application number:
**PCT/JP2004/018562**

(87) International publication number:
**WO 2005/059571 (30.06.2005 Gazette 2005/26)**

(84) Designated Contracting States:
**AT BE BG CH CY CZ DE DK EE ES FI FR GB GR HU IE IS IT LI LT LU MC NL PL PT RO SE SI SK TR**

(30) Priority: **18.12.2003 JP 2003421675**

(71) Applicant: **JSR Corporation**
**Tokyo 104-0045 (JP)**

(72) Inventors:
• **YAMADA, Daisuke,**
**c/o JSR MICROTECH INC.**
**Hidaka-shi, Saitama 3501236 (JP)**
• **KIMURA, Kiyoshi,**
**c/o JSR MICROTECH INC.**
**Hidaka-shi, Saitama 3501236 (JP)**

(74) Representative: **TBK-Patent**
**Bavariaring 4-6**
**80336 München (DE)**

(54) **ANISOTROPIC CONDUCTIVE CONNECTOR AND CIRCUIT DEVICE INSPECTION METHOD**

(57) It is an object to provide an anisotropically conductive connector having an excellent repetitive use durability and a method of inspecting a circuit device having a high inspection efficiency which are used in the inspection of the circuit device such as a semiconductor integrated circuit having a solder projected electrode. A lubricant is applied to the surface of the anisotropically conductive connector. The lubricant is applied to at least a surface on a side which comes in contact with a circuit device to be an inspection target of the anisotropically conductive connector which is used for electrically connecting a circuit board for an inspection to the circuit board to be the inspection target, thereby inspecting the circuit device.

fig.12

## Description

TECHNICAL FIELD

The present invention relates to an anisotropically conductive connector to be used in the inspection of a circuit device such as a semiconductor integrated circuit, and a method of inspecting a circuit device using an apparatus for inspecting a circuit device which is equipped with the anisotropically conductive connector. More particularly, the present invention relates to an anisotropically conductive connector which can be suitably used in the inspection of a circuit device such as a semiconductor integrated circuit having a solder projected electrode, and a method of inspecting a circuit device such as a semiconductor integrated circuit having a solder projected electrode.

BACKGROUND OF THE INVENTION

An anisotropically conductive sheet exhibits a conductivity only in the direction of a thickness or has a pressurizing conductive conductor part exhibiting the conductivity only in the direction of a thickness when it is pressed in the direction of the thickness. The anisotropically conductive sheet has such features that a compact electrical connection can be achieved without using any means such as soldering or mechanical fitting and that a soft connection can be carried out with a mechanical shock or strain absorbed therein. By utilizing such features, therefore, the anisotropically conductive sheet is widely used as an anisotropically conductive connector for achieving an electrical connection between circuit devices, for example, an electrical connection between a printed circuit board and a leadless chip carrier, a liquid crystal panel or the like in the field of an electronic computer, an electronic digital clock, an electronic camera, a computer keyboard or the like, for example.

In the electrical inspection of the circuit device such as the printed circuit board or the semiconductor integrated circuit, moreover, the anisotropically conductive sheet is provided as a connector between the electrode region of the circuit device and the electrode region for an inspection of a circuit board for an inspection in order to achieve the electrical connection of an electrode to be inspected which is formed over a circuit device to be an inspection target and an electrode for an inspection which is formed on the surface of the circuit board for an inspection, for example.

As the anisotropically conductive sheet, conventionally, there have been known various structures such as an anisotropically conductive sheet obtained by uniformly dispersing a metal particle in an elastomer (for example, see Patent Document 1), an anisotropically conducive sheet obtained by unevenly dispersing a conductive magnetic metal in an elastomer, thereby forming a large number of conductive path forming parts extended in the direction of a thickness and an insulating part for mutually insulating them (for example, see Patent Document 2), an anisotropically conductive sheet obtained by defining a difference in level between the surface of the conductive path forming part and the insulating part (for example, see Patent Document 3), and the like.

In these anisotropically conductive sheets, conductive particles are contained in an insulating elastic polymeric substance in the state of an arrangement and orientation in the direction of a thickness, and a conductive path is formed by the chain of a large number of conductive particles.

Such an anisotropically conductive sheet can be manufactured by injecting a molding material containing a conductive particle exhibiting a magnetism in a polymeric substance forming material, which will become an elastic polymeric substance through curing into the molding space of a mold to form a molding material layer, and causing a magnetic field to act on the molding material layer to carry out a curing treatment, for example.

For example, in the case in which a conventional anisotropically conductive sheet is to be used as a connector in the electrical inspection of a circuit device having a projected electrode formed of a solder alloy, however, there is the following problem.

More specifically, by repeating an operation for pressing the projected electrode which is the electrode to be inspected in the circuit device to be an inspection target against the surface of the conductive path forming part in the anisotropically conductive sheet in contact, a permanent deformation is caused by the contact pressing of the protruding electrode and a deformation is generated by an abrasion over the surface of the conductive path forming part in the anisotropically conductive sheet. For this reason, there is a problem in that it is hard to inspect a succeeding circuit device due to an increase in the electrical resistance value of the conductive path forming part in the anisotropically conductive sheet and a variation in the electrical resistance value of each conductive path forming part.

Moreover, a conductive particle for constituting the conductive path forming part which is provided with a covered layer formed of gold is usually used to obtain a high conductivity. By continuously carrying out the electrical inspection of a large number of circuit devices, however, an electrode substance (a solder alloy) constituting the electrode to be inspected in the circuit device is migrated to the covered layer of the conductive particle in the anisotropically conductive sheet. Consequently, the covered layer is reformed. As a result, there is a problem in that the conductivity of the conductive path forming part is reduced.

In order to solve the problems described above, a jig for inspecting the circuit device is constituted by the anisotropically conducive sheet and a sheet-like connector provided with a plurality of metallic electrodes extending to penetrate in the direction of a thickness over a soft insulating sheet formed of a resin material in the inspection of the circuit device, and the electrode to be inspected is pressed in contact with the metallic electrode of the sheet-like connector in the jig for inspecting the circuit device, thereby achieving an electrical connection to the circuit device to be the inspection target (for example, see Patent Document 4).

In the jig for inspecting the circuit device, however, in the case in which the pitch of the electrode to be inspected in the circuit device to be the inspection target is small, that is, the pitch of the metallic electrode in the sheet-like connector is small, it is hard to achieve a predetermined electrical connection to the circuit device. More specifically, in the sheet-like connector in which the pitch of the metallic electrode is small, the metallic electrodes which are adjacent to each other interfere with each other so that a flexibility between the metallic electrodes which are adjacent to each other is deteriorated. For this reason, in the case in which the circuit device to be the inspection target is such that the surface accuracy of a substrate thereof is low, the evenness of the thickness of the substrate is low or a variation in the height of the electrode to be inspected is great, the metallic electrode of the sheet-like connector cannot be reliably caused to come in contact with all of the electrodes to be inspected in the circuit device. As a result, it is impossible to obtain an excellent electrical connection for the circuit device.

Even if the excellent electrical connecting state can be achieved for all of the electrodes to be inspected, moreover, a considerably great pressing force is required. Accordingly, the size of the whole inspecting apparatus is increased, and furthermore, the manufacturing cost of the whole inspecting apparatus is increased.

In the case in which the circuit device is to be inspected under a high-temperature environment, moreover, a positional deviation occurs between the conductive path forming part of the anisotropically conductive sheet and the metallic electrode of the sheet-like connector due to a difference between the coefficient of thermal expansion of an elastic polymeric substance forming the anisotropically conductive sheet and that of a resin material forming an insulating sheet in the sheet-like connector. As a result, it is hard to stably maintain an excellent electrical connecting state.

In the case in which the jig for inspecting a circuit device is to be constituted, moreover, it is necessary to manufacture the sheet-like connector in addition to the manufacture of the anisotropically conductive sheet, and furthermore, to fix them in an alignment state. For this reason, the manufacturing cost of the jig for an inspection is increased.

Moreover, the anisotropically conductive sheet according to the conventional art has the following problems.

More specifically, an elastic polymeric substance forming an anisotropically conductive sheet, for example, silicone rubber has an adhesive property at a high temperature. For this reason, when the anisotropically conductive sheet is left for a long period of time in a state of pressurization carried out by the circuit device under a high-temperature environment, therefore, it adheres to the circuit device. Consequently, it is impossible to smoothly carry out a work for exchanging a circuit device after the completion of an inspection for an uninspected circuit device. As a result, the inspection efficiency of the circuit device is reduced. In the case in which the anisotropically conductive sheet adheres to the circuit device in a great strength, particularly, it is hard to separate the anisotropically conductive sheet from the circuit device without a damage. For this reason, the anisotropically conductive sheet cannot be used for a subsequent inspection.

Patent Document 1 : Japanese Patent Application Laid-Open No. 93393/1976;
Patent Document 2 : Japanese Patent Application Laid-Open No. 147772/1978;
Patent Document 3 : Japanese Patent Application Laid-Open No. 250906/1986; and
Patent Document 4 : Japanese Patent Application Laid-Open No. 231019/1995.

DISCLOSURE OF THE INVENTION

PROBLEMS TO BE SOLVED

The present invention has been made on the basis of the above-mentioned circumstances and has a first object to provide an anisotropically conductive connector, wherein a permanent deformation can be prevented from being caused by the pressure contact of a connecting target electrode and a deformation can be inhibited from being caused by an abrasion even if the connecting target electrode is projected, and a stable conductivity can be obtained for a long period of time even if pressing is carried out repeatedly.

In addition to the first object, a second object of the present invention is to provide an anisotropically conductive connector, wherein the migration of an electrode substance to a conductive particle can be prevented or suppressed and a stable conductivity can be obtained for a long period of time even if an electrode to be inspected is a solder projected electrode, for example, and furthermore, it is possible to prevent or suppress an adhesion to a circuit device also in use in a pressure contact state with the circuit device under a high-temperature environment.

A third object of the present invention is to provide a method of inspecting a circuit device using an apparatus for inspecting a circuit device comprising the anisotropically conductive connector.

MEANS FOR SOLVING THE PROBLEMS

The present invention provides an anisotropically conductive connector to be used for electrically connecting a circuit board for an inspection having an electrode for an inspection which is provided corresponding to an electrode to be inspected in a circuit device to be an inspection target to the circuit device to be the inspection target, wherein a lubricant is applied to at least a surface on a side which comes in contact with the circuit device to be the inspection target.

In the anisotropically conductive connector, it is preferable that the lubricant should be a metal salt of alkyl sulfonic acid.

The present invention provides a method of inspecting a circuit device which serves to electrically connect an electrode to be inspected in a circuit device to be an inspection target to an inspection electrode of a circuit board for an inspection with an anisotropically conductive connector interposed therebetween, thereby carrying out an electrical inspection, wherein the anisotropically conductive connector having a lubricant applied to at least a surface on a side which comes in contact with the circuit device to be the inspection target is used to cause a surface on the inspected electrode side of the circuit device to come in contact with the surface of the anisotropically conductive connector to which the lubricant is applied, thereby carrying out an electrical inspection.

In the inspecting method, it is preferable that the electrode to be inspected in the circuit device to be the inspection target should be a solder projected electrode.

In the inspecting method, it is preferable that the lubricant should be a metal salt of alkyl sulfonic acid.

EFFECT OF THE INVENTION

According to the anisotropically conductive connector, the lubricant is applied to the surface on the inspected circuit device side. Even if the electrode to be inspected is the solder projected electrode, therefore, a permanent deformation can be prevented from being caused by the pressure contact of the portion of the anisotropically conductive connector which comes in contact with the electrode to be inspected and a deformation can be inhibited from being caused by an abrasion. In addition, the migration of the electrode substance of the electrode to be inspected to the conductive particle of the anisotropically conductive connector can be prevented or inhibited. Consequently, it is possible to obtain a stable conductivity for a long period of time.

According to the method of inspecting a circuit device, the lubricant is applied to the surface on the inspected circuit device side. Even if the electrode to be inspected is the solder projected electrode, therefore, a permanent deformation can be prevented from being caused by the pressure contact of the portion of the anisotropically conductive connector which comes in contact with the electrode to be inspected and a deformation can be inhibited frombeing caused by an abrasion. In addition, the migration of the electrode substance of the electrode to be inspected to the conductive particle of the anisotropically conductive connector can be prevented or suppressed. Therefore, the anisotropically conductive connector achieves a stable conductivity for a long period of time and the number of exchanges caused by a deterioration in the anisotropically conductive connector is decreased. As a result, an inspection efficiency can be enhanced.

BRIEF DESCRIPTION OF THE DRAWINGS

Fig. 1 is a plan view showing an example of an anisotropically conductive connector according to the present invention,
Fig. 2 is a cross-sectional view taken along a line A - A, illustrating the anisotropically conductive connector in Fig. 1,
Fig. 3 is an enlarged explanatory cross-sectional view showing a part of the anisotropically conductive connector illustrated in Fig. 1,
Fig. 4 is a plan view showing a supporting body in the anisotropically conductive connector illustrated in Fig. 1,
Fig. 5 is a cross-sectional view taken along a line B — B, illustrating the supporting body in Fig. 4,
Fig. 6 is an explanatory cross-sectional view showing a structure according to an example of a mold for molding an anisotropically conductive film,
Fig. 7 is an explanatory cross-sectional view showing a state in which a spacer and a supporting body are provided on the molding surface of a lower mold,
Fig. 8 is an explanatory cross-sectional view showing a state in which a first molding material layer is formed on the molding surface of an upper mold and a second molding material layer is formed on the molding surface of the lower mold,
Fig. 9 is an explanatory cross-sectional view showing a state in which the first molding material layer and the second molding material layer are laminated,

Fig. 10 is an explanatory cross-sectional view showing a state in which an anisotropically conductive film is formed,

Fig. 11 is an explanatory cross-sectional view showing a state in which the anisotropically conductive film which is formed is taken out of the mold,

Fig. 12 is an explanatory view showing a structure according to an example of an apparatus for inspecting a circuit device in accordance with the present invention together with the circuit device,

Fig. 13 is an explanatory view showing the structure according to the example of the apparatus for inspecting a circuit device in accordance with the present invention together with another circuit device,

Fig. 14 is a plan view showing a circuit device for a test used in an example,

Fig. 15 is a side view showing the circuit device for a test used in the example, and

Fig. 16 is an explanatory view showing the schematic structure of an apparatus for testing a repetitive durability according to the example.

DESCRIPTION OF CHARACTERS

| | |
|---|---|
| 1 | Circuit device |
| 2 | Solder ball electrode |
| 3 | Circuit device for test |
| 5 | Circuit board for inspection |
| 6 | Electrode for inspection |
| 7 | Thermostatic chamber |
| 8 | Wiring |
| 9 | Guide pin |
| 10 | Anisotropically conductive connector |
| 10A | Anisotropically conductive film |
| 11 | Conductive path forming part |
| 11a | Projected portion |
| 12 | Effective conductive path forming part |
| 13 | Non-effective conductive path forming part |
| 15 | Insulating part |
| 40 | Lubricant layer |
| 50 | Upper mold |
| 51 | Ferromagnetic substrate |
| 52 | Ferromagnetic layer |
| 53 | Non-magnetic layer |
| 54a, 54b | Spacer |
| 55 | Lower mold |
| 56 | Ferromagnetic substrate |
| 57 | Ferromagnetic layer |
| 57a | Concave space |
| 58 | Non-magnetic layer |
| 59 | Molding space |
| 61a | First molding material layer |
| 61b | Second molding material layer |
| 71 | Supporting body |
| 72 | Positioning hole |
| 73 | Opening |
| 101 | Anisotropically conductive connector |
| 110 | Voltmeter |
| 115 | DC power source |
| 116 | Constant current control device |

BEST MODE FOR CARRYING OUT THE INVENTION

An embodiment of the present invention will be described below in detail with reference to the drawings.

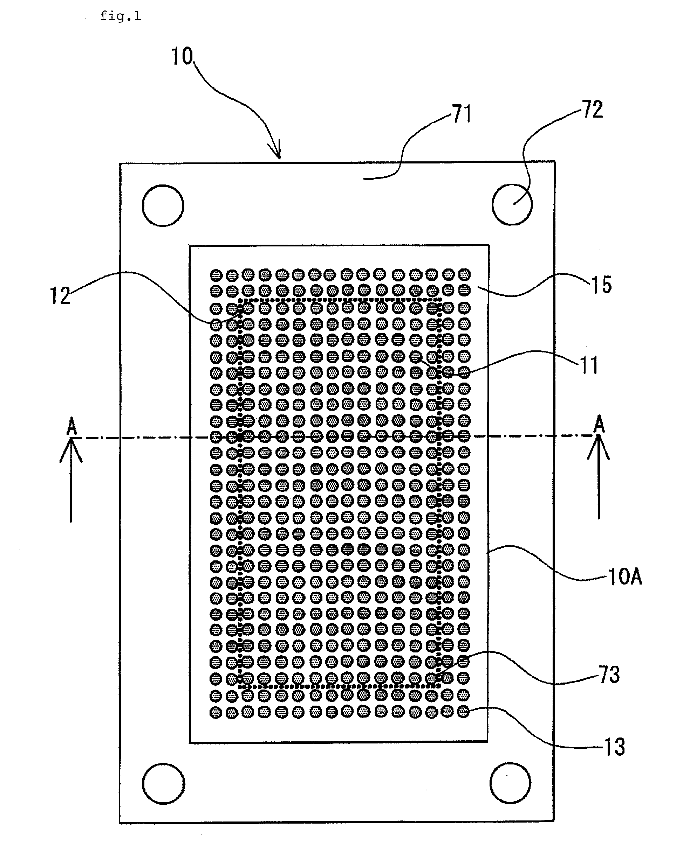

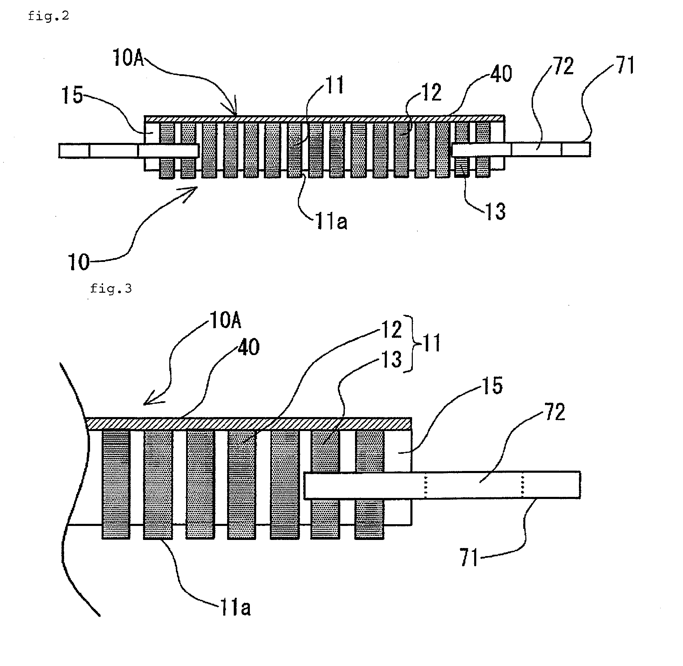

Figs. 1, 2 and 3 are explanatory views showing a structure according to an example of an anisotropically conductive connector in accordance with the present invention, and Fig. 1 is a plan view, Fig. 2 is a cross-sectional view taken along a line A - A in Fig. 1, and Fig. 3 is a partially enlarged cross-sectional view. An anisotropically conductive connector 10 is constituted by an anisotropically conductive film 10A taking a rectangular shape and a rectangular plate-shaped supporting body 71 for supporting the anisotropically conductive film 10A, and is wholly formed like a sheet.

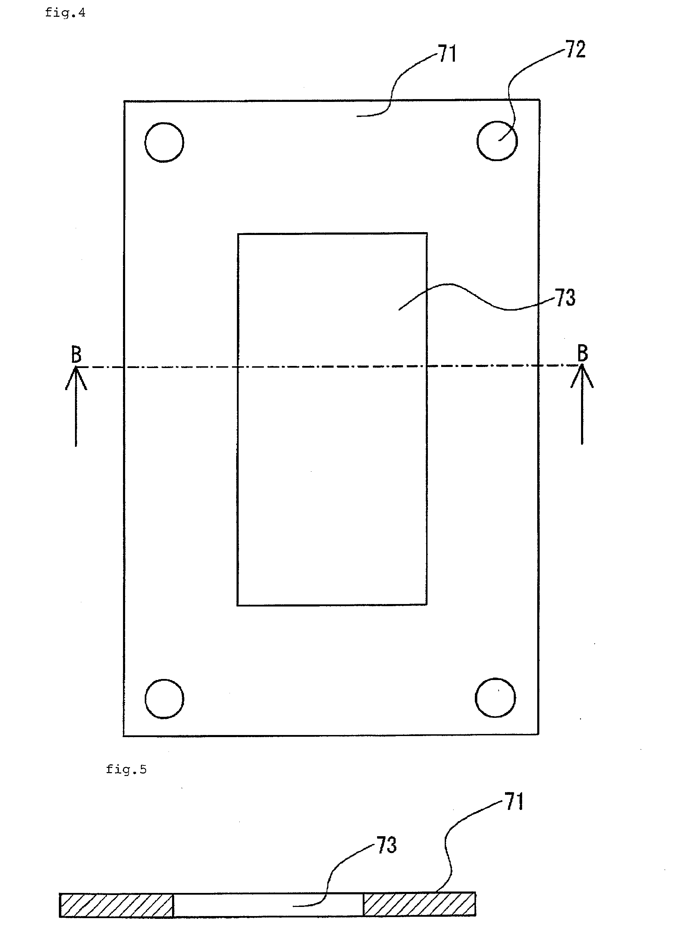

As shown in Figs. 4 and 5, similarly, a rectangular opening 73 having a smaller dimension than the dimension of the anisotropically conductive film 10A is formed in the central position of the supporting body 71, and a positioning hole 72 is formed in each of the positions of four corners. The anisotropically conductive film 10A is arranged in the opening 73 of the supporting body 71, and the peripheral edge portion of the anisotropically conductive film 10A is fixed to the supporting body 71 so that the anisotropically conductive film 10A is supported on the supporting body 71.

The anisotropically conductive film 10A in the anisotropically conductive connector 10 is constituted by a plurality of cylindrical conductive path forming parts 11 extended in the direction of a thickness respectively, and an insulating part 15 formed of an insulating elastic polymeric substance and serving to mutually insulate these conductive path forming parts 11.

Moreover, a portion for forming the conductive path forming part 11 of the anisotropically conductive film 10A contains a conductive particle (not shown) having a magnetism.

In the example shown in the drawing, any of the conductive path forming parts 11 which is formed in a region other than the peripheral edge portion in the anisotropically conductive film 10A is set to be an effective conductive path forming part 12 which is electrically connected to a connecting target electrode, for example, an electrode to be inspected in a circuit device 1 to be an inspection target, and any of the conductive path forming parts 11 which is formed in the peripheral edge portion in the anisotropically conductive part 10A is set to be a non-effective conductive path forming part 13 which is not electrically connected to the connecting target electrode, and the effective conductive path forming part 12 is provided in accordance with a pattern corresponding to the pattern of the connecting target electrode.

On the other hand, the insulating part 15 is formed integrally to surround the individual conductive path forming parts 11. Consequently, all of the conductive path forming parts 11 are insulated from each other by the insulating part 15.

The anisotropically conductive film 10A has one of surfaces to be a plane and the other surface provided with a projected portion 11a in which the surface of a portion forming the conductive path forming path 11 is projected from the surface of a portion forming the insulating part 15.

In the example shown in Figs. 2 and 3, a lubricant is applied to a surface on the plane side of the anisotropically conductive film 10A so that a lubricant layer 40 is provided.

The durometer A hardness of an elastic polymeric substance constituting the anisotropically conductive film 10A is preferably 30 to 70, and more preferably 35 to 65.

In the case in which the durometer A hardness is excessively smaller than 30, the electric resistance value of the conductive path forming part is increased in an early stage due to repetitive use. For this reason, it is hard to obtain a high repetitive durability.

In some cases in which the durometer A hardness is excessively greater than 70, moreover, it is impossible to obtain a conductive path forming part having a high conductivity.

A polymeric substance having a crosslinked structure is preferable for the elastic polymeric substance forming the anisotropically conductive film 10A. Various curable polymeric substance forming materials can be used for obtaining the elastic polymeric substance, and specific examples thereof include conjugated diene rubber such as polybutadiene rubber, natural rubber, polyisoprene rubber, styrene-butadiene copolymer rubber or acrylonitrile-butadiene copolymer rubber, and hydrogenated products thereof; block copolymer rubber such as styrene-butadiene-diene block terpolymer rubber or styrene-isoprene block copolymer rubber, and hydrogenated products thereof; and chloroprene rubber, urethane rubber, polyester rubber, epichlorohydrin rubber, silicone rubber, ethylene-propylene copolymer rubber, ethylene-propylene-diene terpolymer rubber, and the like.

As described above, in the case in which a weather resistance is required for the anisotropically conducive connector 10 thus obtained, it is preferable that materials other than the conjugated diene rubber should be used and it is particularly preferable that the silicone rubber should be used from the viewpoint of molding and processing properties and electrical characteristics.

For the silicone rubber, liquid silicone rubber is preferably crosslinked or condensed. The liquid silicone rubber having a viscosity of $10^5$ poises at a shear proportion of $10^{-1}$ sec is preferably used and may be any of a condensation type, an addition type and those containing a vinyl group or a hydroxyl group. Specific examples include dimethyl silicone raw rubber, methylvinyl silicone raw rubber, methylphenylvinyl silicone raw rubber and the like.

Moreover, it is preferable that the silicone rubber should have a molecular weight Mw (a weight-average molecular weight determined in terms of standard polystyrene and so forth) of 10,000 to 40,000. Moreover, a high heat resistance can be achieved in the conductive path forming part 11 thus obtained. For this reason, it is preferable that a molecular weight distribution index (a value of a ratio Mw/Mn of the weight-average molecular weight Mw determined in terms of standard polystyrene to a number-average molecular weight Mn determined in terms of the standard polystyrene and so forth) should be equal to or smaller than 2.

For the conductive particle contained in the conductive path forming part 11 in the anisotropically conductive film 10A, a conductive particle having a magnetism is used because the same particle can be oriented easily by a method which will be described below. Specific examples of the conductive particle include particles of a metal having a magnetism such as iron, cobalt or nickel, particles of alloys thereof, particles containing these metals or particles obtained by using these particles as core particles and plating the surfaces of the core particles with a metal having a high conductivity such as gold, silver, palladium or rhodium, or particles obtained by using, as the core particles, the particles of a non-magnetic metal, the particles of an inorganic substance such as glass beads or polymer particles and plating the surfaces of the core particles with a conductive magnetic metal such as nickel or cobalt.

Among them, it is preferable to use the particles obtained by using the nickel particles as the core particles and plating the surfaces thereof with gold having a high conductivity.

While means for coating the surfaces of the core particles with the conductive metal is not particularly restricted but there is used a chemical plating, electroplating, sputtering or vapor deposition process or the like, for example.

In the case in which a particle obtained by coating the surface of the core particle with a conductive metal is used as the conductive particle, a coating proportion (a proportion of an area coated with the conductive metal to the surface area of the core particle) of the conductive metal on the particle surface is preferably equal to or higher than 40%, is more preferably equal to or higher than 45%, and is particularly preferably 47 to 95% because a high conductivity can be achieved.

Moreover, the amount of the conductive metal to coat is preferably 0.5 to 50 % by mass, more preferably 2 to 30 % by mass, further preferably 3 to 25 % by mass, and particularly preferably 4 to 20 % by mass based on the core particle. In the case in which the conductive metal to coat is gold, the coating amount thereof is preferably 0.5 to 30 % by mass, more preferably 2 to 20 % by mass, and further preferably 3 to 15 % by mass based on the core particle.

Furthermore, the particle diameter of the conductive particle is preferably 1 to 100 $\mu$m, more preferably 2 to 50 $\mu$m, further preferably 3 to 30 $\mu$m, and particularly preferably 4 to 20 $\mu$m.

Moreover, the particle diameter distribution (Dw/Dn) of the conductive particle is preferably 1 to 10, more preferably 1.01 to 7, further preferably 1.05 to 5, and particularly preferably 1.1 to 4.

By using the conductive particle to satisfy these conditions, the conductive path forming part 11 thus obtained can easily be pressurized and deformed, and furthermore, a sufficient electrical contact can be obtained between the conductive particles in the conductive path forming part 11.

Moreover, the shape of the conductive particle is not particularly restricted but the conductive particle takes the shape of a sphere or an amorphous or is a secondary particle obtained by aggregating them because it can easily be dispersed in a polymeric substance forming material.

In addition, it is possible to properly use a conductive particle having a surface treated with a coupling agent such as a silane coupling agent or a lubricant. By treating the surface of the particle with the coupling agent or the lubricant, it is possible to enhance the durability of the anisotropically conductive connector.

Such a conductive particle is preferably used in a proportion of 5 to 60% and more preferably 7 to 50% in terms of a volume fraction to the polymeric substance forming material. In some cases in which the proportion is lower than 5%, the conductive path forming part 11 having a sufficiently small electric resistance value cannot be obtained. On the other hand, in some cases in which the proportion is more than 60%, the resulting conductive path forming part 11 is apt to be fragile so that a necessary elasticity for the conductive path forming part 11 cannot be obtained.

It is preferable that the conductive particle to be used in the conductive path forming part 11 should have a surface coated with gold. In the case in which a connecting target electrode, for example, an electrode to be inspected in a circuit device to be an inspection target is constituted by a solder alloy containing lead, it is preferable that the conductive particle contained in a side coming in contact with the electrode to be inspected which is constituted by the solder alloy in the conductive path forming part 11 should be coated with a diffusion-resistant metal selected from rhodium, palladium, ruthenium, tungsten, molybdenum, platinum, iridium, silver and alloys containing them. Consequently, it is possible to prevent a lead component from being diffused into the coated layer in the conductive particle.

The conductive particle having the surface coated with the diffusion-resistant metal can be formed by coating the surface of the core particle formed of nickel, iron, cobalt, their alloy or the like with the diffusion-resistant metal through a chemical plating, electroplating, sputtering or vapor deposition process or the like, for example.

Moreover, the coat of the conductive particle can be constituted by a plurality of metal layers. In the case in which the conductive particle is coated with the diffusion-resistant metal, it is preferable that an outermost layer should be formed of the diffusion-resistant metal such as rhodium and an inner coated layer should be formed of gold having a high conductivity, for example.

Furthermore, the coating amount of the diffusion-resistant metal is preferably in a proportion of 5 to 40% and more preferably 10 to 30% in terms of a mass fraction to the conductive particle.

A material constituting the supporting body 71 to be used preferably has a coefficient of linear thermal expansion of $3 \times 10^{-5}$ / K or less, more preferably $2 \times 10^{-5}$ to $1 \times 10^{-6}$ / K and particularly preferably $6 \times 10^{-6}$ to $1 \times 10^{-6}$ / K.

For a specific material, a metal material or a non-metal material is used.

For the metal material, it is possible to use gold, silver, copper, iron, nickel, cobalt or their alloy.

For the non-metal material, it is possible to use a resin material having a high mechanical strength such as a polyimide resin, a polyester resin, a polyaramid resin or a polyamide resin, a composite resin material such as a glass fiber-reinforced epoxy resin, a glass fiber-reinforced polyester resin or a glass fiber-reinforced polyimide resin, or a composite resin material with an inorganic material such as silica, alumina or boron nitride mixed as a filler into an epoxy resin or the like. The composite resin material such as the polyimide resin or the glass fiber-reinforced epoxy resin, or the composite resin material such as an epoxy resin with boron nitride mixed as a filler is preferred because of a small coefficient of thermal expansion.

Various lubricants to be applied to the surface of the anisotropically conductive connector can be used if the permanent deformation of the anisotropically conductive connector and the migration of an electrode substance to the conductive particle of the anisotropically conductive connector can be suppressed in the pressure contact of the anisotropically conductive connector with the electrode to be inspected in the circuit device to be the inspection target.

Specific examples of the lubricant include a fluororesin type lubricant, a lubricant containing, as a main agent, an inorganic material such as boron nitride, silica, zirconia, silicon carbide or graphite; a hydrocarbon type mold-releasing agent such as a paraffin type wax, metal soap, natural and synthetic paraffins, polyethylene waxes or fluorocarbons; a fatty acid type mold-releasing agent such as higher fatty acid, for example, stearic acid or hydroxystearic acid or oxyfatty acids; a fatty amide type mold-releasing agent such as fatty amide, for example, amide stearate or ethylene-bis-stearamide, or alkylene-bis-fatty amides; an alcohol type mold-releasing agent such as aliphatic alcohol, for example, stearyl alcohol or cetyl alcohol, polyvalent alcohol, polyglycol or polyglycerols; a fatty ester type mold-releasing agent such as aliphatic acid lower alcohol ester, for example, butyl stearate or pentaerythritol tetrastearate, fatty polyvalent alcohol ester, or fatty polyglycol esters; a silicone type mold-releasing agent such as silicone oils; a metal salt of alkyl sulfonic acid, and the like.

Among them, a metal salt of alkyl sulfonic acid is preferred in that the permanent deformation of an anisotropically conductive connector and the migration of an electrode substance to the conductive particle of the anisotropically conductive connector are suppressed in the pressure contact of the anisotropically conductive connector with the electrode to be inspected in the circuit device to be the inspection target, and a bad influence such as the contamination of the electrode to be inspected in the circuit device to be the inspection target is lessened, particularly, a bad influence in use at a high temperature is lessened.

An alkaline metal salt is preferable for the metal salt of alkyl sulfonic acid, and specific examples thereof include 1 - sodium decanoic sulfonate, 1 - sodium undecanoic sulfonate, 1 - sodium dodecanoic sulfonate, 1 - sodium tridecanoic sulfonate, 1 - sodium tetradecanoic sulfonate, 1 - sodium pentadecanoic sulfonate, 1 - sodium hexadecanoic sulfonate, 1 - sodium heptadecanoic sulfonate, 1 - sodium octadecanoic sulfonate, 1 - sodium nonadecanoic sulfonate, 1 - sodium eicosanoic decanoic sulfonate, 1 - potassium decanoic sulfonate, 1 - potassium undecanoic sulfonate, 1 - potassium dodecanoic sulfonate, 1 - potassium tridecanoic sulfonate, 1 - potassium tetradecanoic sulfonate, 1 - potassium pentadecanoic sulfonate, 1 - potassium hexadecanoic sulfonate, 1 - potassium heptadecanoic sulfonate, 1 - potassium octadecanoic sulfonate, 1 - potassium nonadecanoic sulfonate, 1 - potassium eicosanoic decanoic sulfonate, 1-lithium decanoic sulfonate, 1-lithium undecanoic sulfonate, 1-lithium dodecanoic sulfonate, 1-lithium tridecanoic sulfonate, 1-lithium tetradecanoic sulfonate, 1-lithium pentadecanoic sulfonate, 1-lithium hexadecanoic sulfonate, 1-lithium heptadecanoic sulfonate, 1-lithium octadecanoic sulfonate, 1-lithium nonadecanoic sulfonate, 1-lithium eicosanoic decanoic sulfonate, and their isomers.

Among these compounds, the sodium salt is particularly preferable because of a high heat resistance.

These compounds may be used singly or in combination.

The amount of the lubricant to be applied to the surface of the anisotropically conductive connector may be such that the circuit device to be the inspection target does not stick to the anisotropically conductive connector but the electrode to be inspected in the circuit device to be the inspection target in the inspection and use after the inspection is not influenced.

For a method of applying the lubricant to the anisotropically conductive connector, it is possible to use well-known methods, for example, coating by a spray method or with a brush, the dropping of a solution onto a surface to be applied, the lipping of the anisotropically conductive connector in the solution, and the like.

In these applying methods, it is possible to properly utilize a method of diluting the lubricant with a solvent such as alcohol, applying the diluted solution to the surface of the conductive particle and then vaporizing the solvent. According to such a method, it is possible to uniformly apply the lubricant to the surface of the conductive particle.

It is also possible to use a method of putting a lubricant in a solid powder state at an ordinary temperature in a proper amount on the surface to be applied in the anisotropically conductive connector and heating the anisotropically conductive connector to a high temperature, thereby melting the lubricant and applying the lubricant to the surface.

The anisotropically conductive connector 10 can be manufactured in the following manner, for example.

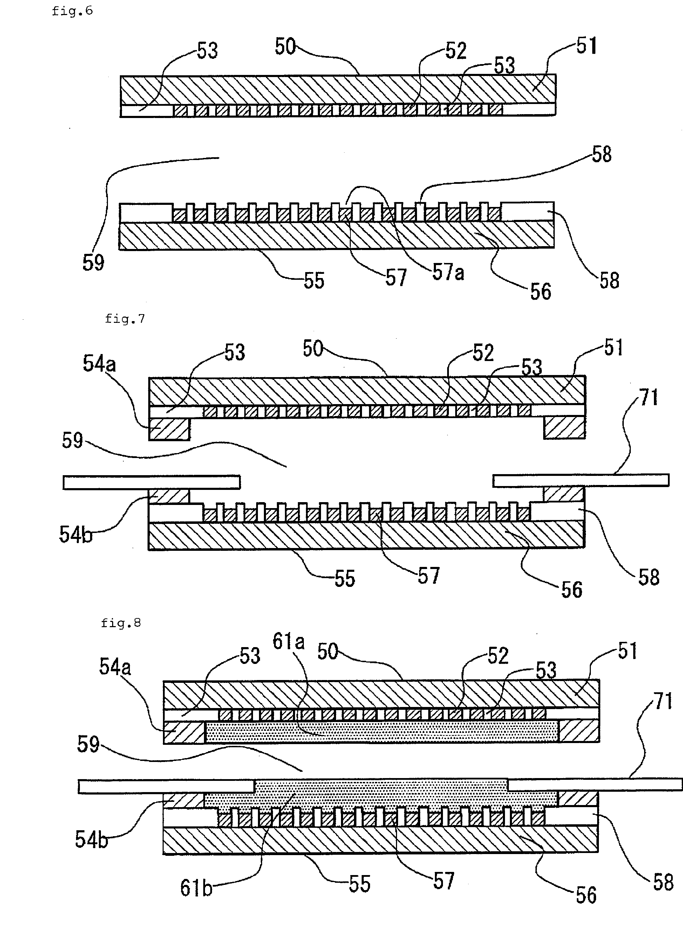

Fig. 6 is an explanatory cross-sectional view showing a structure according to an example of a mold to be used for manufacturing the anisotropically conductive connector in accordance with the present invention. The mold is constituted by an upper mold 50 and a lower mold 55 making a pair therewith which are opposed to each other, and a molding space 59 is formed between the molding surface of the upper mold 50 (a lower surface in Fig. 6) and the molding surface of the lower surface 55 (an upper surface in Fig. 6).

In the upper mold 50, a ferromagnetic layer 52 is formed on the surface of a ferromagnetic substrate 51 (a lower surface in Fig. 6) in accordance with an arrangement pattern corresponding to the pattern of the conductive path forming part 11 in the intended anisotropically conductive connector 10, and a non-magnetic layer 53 having a thickness which is substantially equal to the thickness of the ferromagnetic layer 52 is formed in portions other than the ferromagnetic layer 52.

On the other hand, a ferromagnetic layer 57 is formed on the surface of a ferromagnetic substrate 56 (an upper surface in Fig. 6) in accordance with a pattern corresponding to the pattern of the conductive path forming part 11 in the intended anisotropically conductive connector 10, and a non-magnetic layer 58 having a greater thickness than the thickness of the ferromagnetic layer 57 is formed in portions other than the ferromagnetic layer 57. A step is formed between the non-magnetic layer 58 and the ferromagnetic layer 57 so that a concave space 57a for forming the projected portion 11a is provided on the molding surface of the lower mold 55.

As a material constituting the ferromagnetic substrates 51 and 56 in the upper mold 56 and the lower mold 55, it is possible to use a ferromagnetic metal such as iron, an iron - nickel alloy, an iron - cobalt alloy, nickel or cobalt. It is preferable that the ferromagnetic substrates 51 and 56 should have thicknesses of 0.1 to 50 mm and should have smooth surfaces and be subjected to a chemical degreasing treatment and a mechanical polishing treatment.

As a material constituting the ferromagnetic layers 52 and 57 in the upper mold 50 and the lower mold 55, moreover, it is possible to use a ferromagnetic metal such as iron, an iron - nickel alloy, an iron - cobalt alloy, nickel or cobalt. It is preferable that the ferromagnetic layers 52 and 57 should have thicknesses of $10\mu$m or more. In the case in which the thickness is smaller than $10\mu$m, it is hard to cause a magnetic field having a sufficient strength distribution to act on the molding material layer to be formed in the mold. As a result, it is difficult to collect conductive particles in a high density in a portion to be the conductive path forming part 11 in the molding material layer. In some cases, therefore, it is impossible to obtain an anisotropically conductive connector which is excellent.

As a material constituting the non-magnetic layers 53 and 58 in the upper mold 50 and the lower mold 55, furthermore, it is possible to use a non-magnetic metal such as copper, a polymeric substance having a heat resistance or the like. It is preferable to use a polymeric substance cured by a radiation in that the non-magnetic layers 53 and 58 can easily be formed by a technique of photolithography. As the material, it is possible to use a photoresist such as an acrylic dry film resist, an epoxy type liquid resist or a polyimide type liquid resist.

Moreover, the thickness of the non-magnetic layer 58 in the lower mold 55 is set corresponding to the projection height of the projected portion 11a and the thickness of the ferromagnetic layer 57 which are to be formed.

By using the mold, for example, the anisotropically conductive connector 10 is manufactured in the following manner.

First of all, as shown in Fig. 7, frame-shaped spacers 54a and 54b and the supporting body 71 having the opening 73 and the positioning hole 72 shown in Figs. 4 and 5 are prepared, and the supporting body 71 is fixed to the predetermined position of the lower mold 55 through the frame-shaped spacer 54b, and furthermore, the frame-shaped spacer 54a is provided in the upper mold 50.

On the other hand, a conductive particle exhibiting a magnetism is dispersed into a curable polymeric substance forming material to prepare a paste-like molding material.

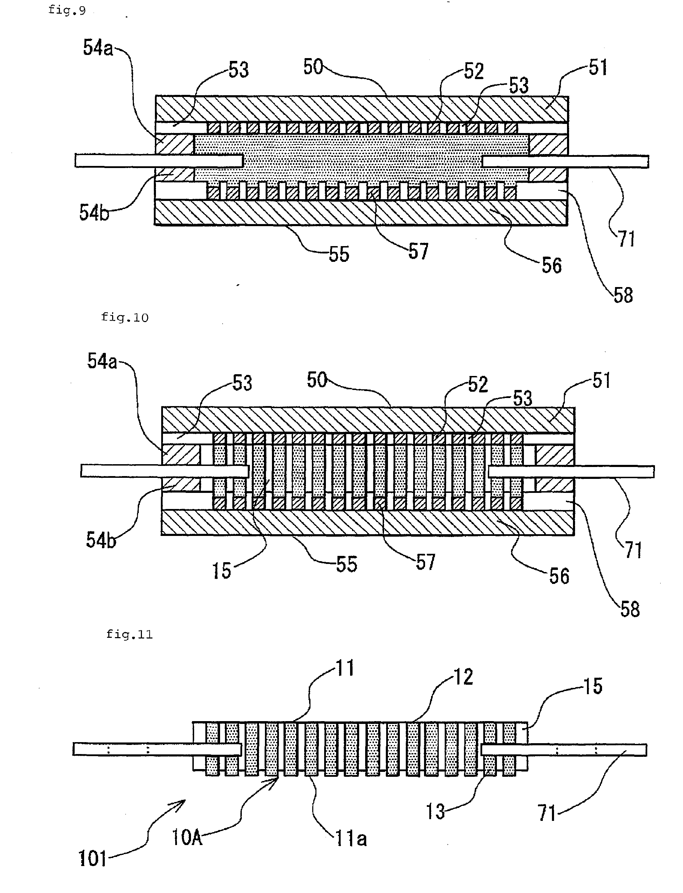

As shown in Fig. 8, subsequently, the molding material is filled in a space formed by the spacer 54a on the molding surface of the upper mold 50 to form a first molding material layer 61a. On the other hand, the molding material is filled in a space formed by the lower mold 55, the spacer 54b and the supporting body 71 to form a second molding material layer 61b.

As shown in Fig. 9, the upper mold 50 is aligned and provided on the supporting body 71 so that the first molding material layer 61a is laminated on the second molding material layer 61b.

Next, an electromagnet (not shown) provided on the upper surface of the ferromagnetic substrate 51 in the upper mold 50 and the lower surface of the ferromagnetic substrate 56 in the lower mold 55 is operated to cause a parallel magnetic field having an intensity distribution, that is, a parallel magnetic field having a high intensity between the ferromagnetic layer 52 of the upper mold 50 and the ferromagnetic layer 57 of the lower mold 55 corresponding thereto to act in the direction of the thickness of the first molding material layer 61a and the second molding material layer 61b. As a result, in the first molding material layer 61a and the second molding material layer 61b, the conductive particles dispersed in each of the molding material layers are gathered in a portion to be the conductive path forming part 11 positioned between each of the ferromagnetic layers 52 of the upper mold 50 and each of the ferromagnetic layers 57 of the lower mold 55 corresponding thereto and are arranged in the direction of the thickness of each of the molding material layers.

In this condition, each of the molding material layers is subjected to a curing treatment. As shown in Fig. 10, consequently, there is formed an anisotropically conductive film 10A having the conductive path forming part 11 filled densely in a state in which the conductive particles are arranged in the direction of a thickness in an elastic polymeric substance and the insulating part 15 formed by an insulating elastic polymeric substance having no conductive particle or very few conductive particles in order to surround the conductive path forming part 11.

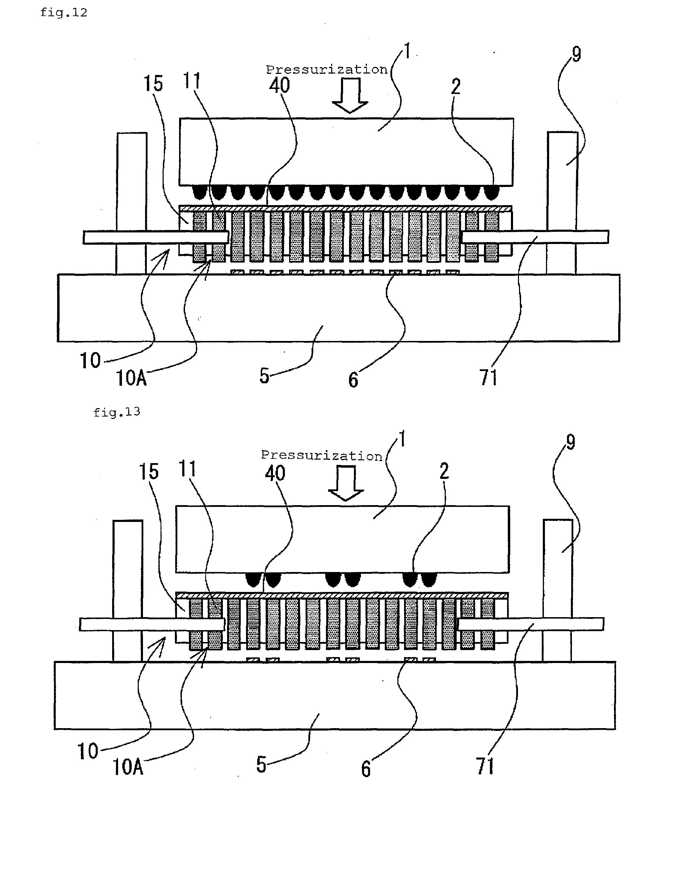

Then, the anisotropically conductive connector is taken out after the molding through the mold. Consequently, there is obtained an anisotropically conductive connector 101 having a structure shown in Fig. 11 and having no lubricant applied thereto.

The lubricant is applied to one of the surface sides of the anisotropically conductive connector (an upper side in Fig. 11) to provide the lubricant layer 40. Consequently, the anisotropically conductive connector 10 having the structure shown in Figs. 1 to 3 is manufactured.

As described above, the curing treatment of each of the molding material layers can be carried out in a state in which the parallel magnetic field is maintained to act and can also be performed after the action of the parallel magnetic field is stopped.

It is preferable that the intensity of the parallel magnetic field to act on each of the molding material layers should be 20,000 to 1,000,000 $\mu$T on an average.

As means for causing the parallel magnetic field to act on each of the molding material layers, moreover, it is also possible to use a permanent magnet in place of an electromagnet. A permanent magnet formed of Alnico (Fe-Al-Ni-Co type alloy) ferrite or the like is preferable in that the intensity of the parallel magnetic field within the above range can be obtained.

The curing treatment of each of the molding material layers is properly selected depending on a material to be used and a heating treatment is usually carried out. Specific heating temperature and heating time are properly selected in consideration of the type of a polymeric substance forming material constituting the molding material layer or the like, a time required for the movement of the conductive particle, and the like.

Fig. 12 is a schematic explanatory view showing a structure according to an example of an apparatus for inspecting a circuit device in accordance with the present invention.

The apparatus for inspecting a circuit device is provided with a circuit board 5 for an inspection which has a guide pin 9. An electrode 6 for an inspection is formed on the surface of the circuit board 5 for an inspection (the upper surface in Fig. 1) in accordance with a pattern corresponding to the pattern of a hemispherical solder ball electrode 2 in the circuit device 1 to be an inspection target.

The anisotropically conductive connector 10 having the structure shown in Figs. 1 to 3 is provided on the surface of the circuit board 5 for an inspection. More specifically, the guide pin 9 is inserted in the positioning hole 72 (see Figs. 1 to 3) formed on the supporting body 71 in the anisotropically conductive connector 10 so that the anisotropically conductive connector 10 is fixed onto the surface of the circuit board 5 for an inspection in a state in which the conductive path forming part 11 in the anisotropically conductive film 10A is positioned on the electrode 6 for an inspection, and a lubricant is applied onto a surface at the side of the anisotropically conductive film 10A which comes in contact with the circuit device 1 so that a lubricant layer 40 is formed.

In the apparatus for inspecting a circuit device, the circuit device 1 is provided on the anisotropically conductive connector 10 in such a manner that the solder ball electrode 2 is positioned on the conductive path forming part 11, and the circuit device 1 is pressed in such a direction as to approach the circuit board 5 for an inspection in this state, for example. Consequently, each of the conductive path forming parts 11 in the anisotropically conductive connector 10 is interposed and pressed between the solder ball electrode 2 and the electrode 6 for an inspection. As a result, an electrical connection can be achieved between each of the solder ball electrodes 2 of the circuit device 1 and each of the electrodes 6 for an inspection in the circuit board 5 for an inspection. In this inspection state, the circuit device 1 is inspected.

According to the apparatus for inspecting a circuit device, there is provided the anisotropically conductive connector 10 in which the lubricant is applied to the side of the anisotropically conductive film 10A with which the circuit device comes in contact. Even if the electrode to be inspected is the projected solder ball electrode 2, therefore, it is possible to prevent a permanent deformation or a deformation by an abrasion from being caused over the anisotropically conductive film 10A due to the pressure contact of the electrode to be inspected so that it is possible to prevent or suppress the migration of the electrode substance of the solder ball electrode 2 to the conductive particle. Also in the case in which a large number of circuit devices 1 are inspected continuously, therefore, it is possible to obtain a stable conductivity for a long period of time.

In addition, also in the case in which the anisotropically conductive connector 10 is used in a pressure contact with the circuit device 1 in a high-temperature environment, it is possible to prevent or suppress the adhesion of the anisotropically conductive connector 10 to the circuit device 1.

In the anisotropically conductive connector 10, moreover, a permanent deformation or a deformation by an abrasion is prevented from being caused by a pressure contact with the electrode to be inspected. In addition to the anisotropically conductive connector 10, therefore, it is possible to electrically inspect the circuit device without using a sheet-like connector.

In the case in which the sheet-like connector is not used, an alignment of the anisotropically conductive connector 10 and the sheet-like connector is not required and it is possible to avoid a problem of a positional deviation between the sheet-like connector and the anisotropically conductive connector 10 due to a change in a temperature, and furthermore, the inspecting apparatus can be constituted easily.

The present invention is not restricted to the embodiment described above but various changes can be made.

(1) In the case in which the anisotropically conductive connector according to the present invention is to be used for the electrical inspection of the circuit device, the electrode to be inspected in the circuit device to be the inspection target is not restricted to the hemispherical solder ball electrode but may be a lead electrode or a plate-shaped electrode, for example.

(2) It is not essential to provide the supporting body in the anisotropically conductive connector but the anisotropically conductive connector may be formed by only the anisotropically conductive film.

(3) In the case in which the anisotropically conductive connector according to the present invention is to be used in the electrical inspection for the circuit device, the anisotropically conductive film may be bonded integrally with the circuit board for an inspection. According to such a structure, it is possible to reliably prevent a positional deviation between the anisotropically conductive film and the circuit board for an inspection.

It is possible to manufacture such an anisotropically conductive connector by using a mold for manufacturing the anisotropically conductive connector which has a space region for a substrate arrangement capable of providing the circuit board 5 for an inspection in a molding space, providing the circuit board for an inspection in the space region for a substrate arrangement in the molding space of the mold and injecting a molding material into the molding space to carry out a curing treatment, for example, in this condition.

(4) The lubricant may be applied to both sides of the anisotropically conductive connector.

By applying the lubricant to the circuit board side for an inspection in addition to the side of the conductive film of the anisotropically conductive connector which comes in contact with the circuit device, it is possible to further enhance the repetitive use durability of the anisotropically conductive connector in the inspection.

(5) In the anisotropically conductive connector according to the present invention, the conductive path forming parts may be arranged at a constant pitch and a part of the conductive path forming parts may be set to be effective conductive path forming parts to be electrically connected to the electrode to be inspected and the other conductive path forming parts may be set to be non-effective conductive path forming parts which are not electrically connected to the electrode to be inspected.

More specifically, as shown in Fig. 13, some circuit devices 1 to be inspection targets have a structure in which the solder ball electrodes 2 which are electrodes to be inspected are arranged only in a part of the positions of lattice points at a constant pitch, for example, CSP (Chip Scale Package), TSOP (Thin Small Outline Package) or the like. In the anisotropically conductive connector 10 for inspecting the circuit device 1, the conductive path forming part 11 may be provided in accordance with the position of the lattice point at a substantially equal pitch to the electrode to be inspected, and the conductive path forming part 11 placed in a position corresponding to the electrode to be inspected may be set to be the effective conductive path forming part and the other conductive path forming parts 11 may be set to be the non-effective conductive path forming parts.

According to the anisotropically conductive connector 10 having such a structure, in the manufacture of the anisotropically conductive connector 10, the ferromagnetic layers of the mold are arranged at a constant pitch. When a magnetic field is caused to act on the molding material layer, consequently, the conductive particles can be efficiently gathered and oriented in predetermined positions. Thus, the densities of the conductive particles can be made equal to each other in the conductive path forming parts which are obtained, respectively. Therefore, it is possible to obtain the anisotropically conductive connector having a small difference between the resistance values of the conductive path forming parts.

(6) The anisotropically conductive connector according to the present invention can contain a reinforcing material. For such a reinforcing material, it is possible to suitably use a material constituted by a mesh or a nonwoven fabric. By causing the reinforcing material to be contained in the anisotropically conductive film, the deformation of the conductive path forming part can be suppressed still more even if pressing is repetitively carried out by a connecting target electrode. Consequently, it is possible to obtain a much more stable conductivity for a long period of time.

The mesh or the nonwoven fabric constituting the reinforcing material which is formed by an organic fiber can be used suitably. Examples of the organic fiber include a fluororesin fiber such as a polytetrafluoroethylene fiber, an aramid fiber, a polyethylene fiber, a polyallylate fiber, a nylon fiber, a polyester fiber, a liquid crystal polymer fiber and the like.

By using an organic fiber having a coefficient of linear thermal expansion which is equal to or approximate to that of a material forming a connecting target body, specifically, a coefficient of linear thermal expansion of $3 \times 10^{-5}$ to $5 \times 10^{-6}$ / K, particularly, $1 \times 10^{-5}$ to $3 \times 10^{-6}$ / K, it is possible to suppress the thermal expansion of the anisotropically conductive film. Also in the case in which a thermal history based on a change in a temperature is received, therefore, it is possible to stably maintain an excellent electrical connecting state for the connecting target body.

Moreover, it is preferable that an organic fiber having a diameter of 10 to 200$\mu$m should be used.

(7) The anisotropically conductive film needs to have neither the conductive path forming part nor the insulating part and may have a configuration in which the conductive particles are dispersed in a planar direction and are oriented in the direction of a thickness.

Such an anisotropically conductive film can be manufactured by the method disclosed in Japanese Patent Application Laid-Open No. 77560/2003.

<Example>

Specific examples of the present invention will be described below and the present invention is not restricted to the following examples.

[Addition type liquid silicone rubber]

In the following examples and comparative examples, addition type liquid silicone rubber was of a two-liquid type in which a liquid A has a viscosity of 500Pa·s and a liquid B has a viscosity of 500Pa·s, and a cured product having a compression set of 6%, a durometer A hardness of 42 and a tear strength of 30 kN/m was used.

The characteristics of the addition type liquid silicone rubber were measured in the following manner.

(1) Viscosity of addition type liquid silicone rubber:

A viscosity at 23±2°C was measured by means of a Brookfield type viscometer.

(2) Compression set of cured product of silicone rubber:

The liquids A and B in the addition type liquid silicone rubber of the two-liquid type were stirred and mixed in proportions that their amounts are equal to each other. After this mixture was then poured into a mold and was subjected to a defoaming treatment by a pressure reduction, a curing treatment was conducted under conditions of 120°C for 30 minutes, thereby producing a columnar body formed of a cured product of the silicone rubber which has a thickness of 12.7 mm and a diameter of 29 mm. The columnar body was post-cured under conditions of 200°C for 4 hours. The columnar body thus obtained was used as a specimen to measure a compression set at 150±2°C in accordance with JIS K 6249.

(3) Tear strength of cured product of silicone rubber:

The curing treatment and post curing for the addition type liquid silicone rubber was conducted under the same conditions as in (2), thereby producing a sheet having a thickness of 2.5 mm. A crescent type specimen was prepared by punching this sheet to measure a tear strength at 23±2°C in accordance with the JIS K 6249.

(4) Durometer hardness of cured product of silicone rubber:

Five sheets produced in the same manner as in (3) were stacked on one another, and the resultant laminate was used as a specimen to measure a durometer A hardness at 23±2°C in accordance with the JIS K 6249.

<Example 1>

(a) Production of supporting body and mold

A supporting body having the structure shown in Fig. 4 and a mold for molding an anisotropically conductive film having the structure shown in Fig. 6 were produced in accordance with the following conditions.

[Supporting body]

A supporting body (71) is such that its material is SUS304, a thickness is 0.1 mm, the dimension of an opening (73) is 17 mm by 10 mm, and positioning holes (72) are provided at four corners.

[Mold]

Ferromagnetic substrates (51, 56) are such that their materials are iron and a thickness is 6 mm.

Ferromagnetic layers (52, 57) of an upper mold (50) and a lower mold (55) are such that their materials are nickel, a diameter is 0.45 mm (circular), a thickness is 0.1 mm, an arrangement pitch (center distance) is 0.8 mm, and the number of the ferromagnetic layers is 288 (12 x 24).

Non-magnetic layers (53, 58) are such that their materials are dry film resists subjected to a curing treatment, the thickness of the non-magnetic layer (53) of the upper mold (50) is 0.1 mm and the thickness of the non-magnetic layer (58) of the lower mold (55) is 0.15 mm.

A molding space (59) formed by the mold is 20 mm by 13 mm in dimensions.

(b) Preparation of molding material:

60 parts by weight of conductive particles having an average particle diameter of $30\mu m$ were added to and mixed with 100 parts by weight of the addition type liquid silicone rubber. Thereafter, the resultant mixture was subjected to a defoaming treatment by a pressure reduction, thereby preparing a first molding material. In the above-described process, those (average coating amount : 20% by weight of the weight of core particles) obtained by plating core particles composed of nickel with gold were used as the conductive particles.

Moreover, 60 parts by weight of conductive particles having an average particle diameter of $30\mu m$ were added to and mixed with 100 parts by weight of the addition type liquid silicone rubber. Thereafter, the resultant mixture was subj ected to the defoaming treatment by the pressure reduction, thereby preparing a second molding material. In the above-described process, those (average coating amount : 20% by weight of the weight of core particles) obtained by plating core particles composed of nickel with gold were used as the conductive particles.

(c) Formation of anisotropically conductive film

A spacer (54a) having a thickness of 0.2 mm which is provided with an opening of 20 mm by 13 mm in dimensions was arranged on the molding surface of the upper mold (50) of the mold in alignment, and a prepared molding material was applied by screen printing so that a first molding material layer (61a) having a thickness of 0.2 mm was formed.

Moreover, a spacer (54b) having a thickness of 0.2 mm which is provided with a rectangular opening of 20 mm by 13 mm in dimensions was arranged on the molding surface of the lower mold (55) of the mold in alignment, the supporting body (71) was arranged on the spacer (54b) in alignment, and a prepared molding material was applied by the screen printing so that a second molding material layer (61b) having a thickness of 0.3 mm was provided in a space formed by the lower mold (55), the spacer (54b) and the supporting body (71).

Then, the first molding material layer (61a) formed on the upper mold (50) and the second molding material layer (61b) formed on the lower mold (55) were stacked on each other in alignment.

Thereafter, the respective molding material layers formed between the upper mold (50) and the lower mold (55) were subjected to a curing treatment under conditions of 100°C for 1 hour while applying a magnetic field of 2T to portions located between the ferromagnetic layers (52, 57) in the direction of the thickness by an electromagnet, thereby forming an anisotropically conductive film (10A).

As described above, an anisotropically conductive connector (10) according to the present invention was manufactured.

The anisotropically conductive film (10A) of the anisotropically conductive connector (10) thus obtained takes the shape of a rectangle having a dimension of 20 mm by 13 mm, and has 288 (12 x 24) conductive path forming parts (11), and each of the conductive path forming parts (11) has a diameter of 0.45 mm and has an arrangement pitch (center distance) of 0.8 mm.

The anisotropically conductive connector will be hereinafter referred to as an "anisotropically conductive connector A1".

<<Application of lubricant>>

A 0.5 wt% methanol solution containing sodium alkane sulfonate ($C_nH_{2n+1}SO_3Na$ (n = 12 to 20)) was prepared.

0.5 ml of the 0. 5 wt% methanol solution containing sodium alkane sulfonate was applied onto one of the surfaces (an upper surface side) of the anisotropically conductive film (10A) of the anisotropically conductive connector A1 and drying was carried out at an ordinary temperature, and furthermore, the drying was carried out at 125°C so that there was obtained an anisotropically conductive connector in which the lubricant was applied onto the surface of the anisotropically conductive film.

The anisotropically conductive connector will be hereinafter referred to as an "anisotropically conductive connector B1".

[Evaluation of anisotropically conductive connector]

With respect to the anisotropically conductive connector B1 having the lubricant applied thereto, its performance was evaluated in the following manner.

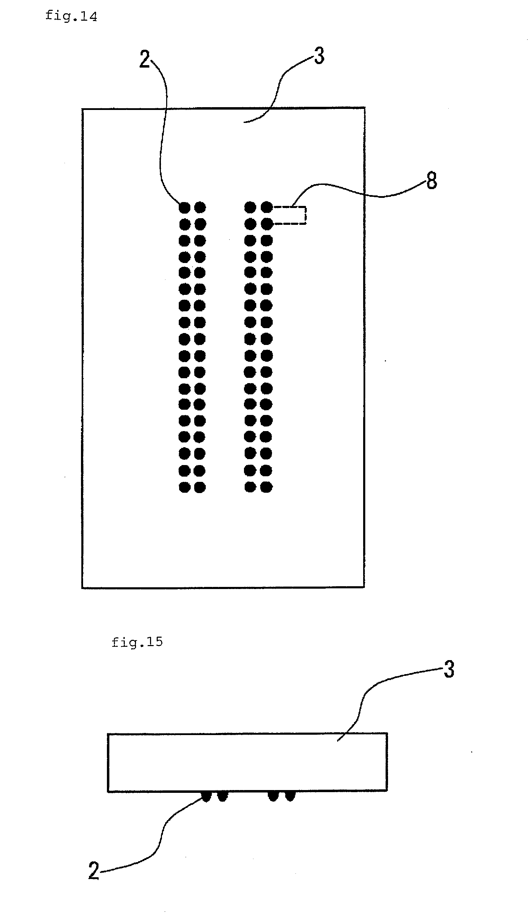

A circuit device (3) for a test shown in Figs. 14 and 15 was prepared.

The circuit device (3) for a test has 72 solder ball electrodes (2) (material : lead-free solder) in total, each of which has a diameter of 0.4 mm and a height of 0.3 mm. Two electrode groups are formed, each of which has 36 solder ball electrodes (2) provided therein. In each of the electrode groups, there are formed two lines in total, each of which has 18 solder ball electrodes (2) arranged straight at a pitch of 0.8 mm. Two of the solder ball electrodes are electrically connected to each other through a wiring (8) in the circuit device (3). The total number of the wirings in the circuit device (3) is 36.

By using each of the circuit devices for a test, the anisotropically conductive connector was evaluated in the following manner.

<<Repetitive durability>>

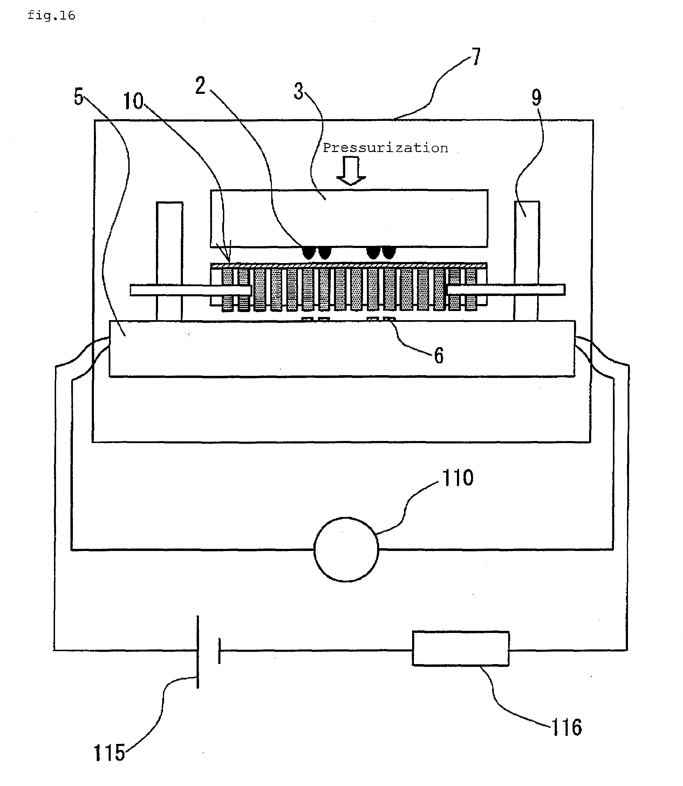

As shown in Fig. 16, the anisotropically conductive connector (10) was positioned on a circuit board (5) for an inspection by inserting guide pins (9) of the circuit board (5) for an inspection into the positioning holes of the supporting body (71) in the anisotropically conductive connector (10), and the circuit device (3) for a test was arranged on the anisotropically conductive connector (10). These were fixed by a pressurizing jig (not shown) and were arranged within a thermostatic chamber (7) in this state.

Subsequently, a temperature within the thermostatic chamber (7) was set to be 25°C and a load of 1.2 kg was applied to the circuit device for a test by means of a pressurizing jig and was held for 20 seconds, and a current of 500 mA was applied for 0.1 second at 12 times during the pressurization for 20 seconds, and a resistance value was thus measured every current application.

After the pressurization for 20 seconds, the pressurization was cancelled and a non-pressurization state was held for 5 seconds. This operation was set to be one pressurizing cycle. By repeating the pressurizing cycle, the anisotropically conductive connector was evaluated.

The electric resistance value was measured in the following manner. A DC current of 10 mA was always applied by a DC power supply (115) and a constant current control device (116) between external terminals (not shown) of the circuit board (5) for an inspection which are electrically connected to each other through the anisotropically conductive connector (10), the circuit device (3) for a test, and an electrode (6) for an inspection and a wiring thereof (not shown) of the circuit board (5) for an inspection, and a voltage between the external terminals of the circuit board (5) for an inspection during the pressurization was measured by means of a voltmeter (110).

An electric resistance value $R_1$ was calculated by the following equation, wherein a value (V) of the voltage thus measured is represented by $V_1$ and the applied DC current is represented by $I_1$ (= 10 mA).

$$[Equation\ 1]$$

$$R_1 = V_1 / I_1$$

The electric resistance value $R_1$ includes an electric resistance value between the electrodes of the circuit device (3) for a test and an electric resistance value between the external terminals of the circuit board for an inspection in addition to the electric resistance values of the two conductive path forming parts.

When the electric resistance value $R_1$ is greater than 1 Q , it is actually hard to electrically inspect the circuit device. For this reason, the voltage was continuously measured until the electric resistance value $R_1$ exceeded 1Ω.

Then, there was recorded the number of measurements (the number of current applications) at which a greater value than 1Ω was measured for the electric resistance value $R_1$ of one of 36 wirings in the circuit device (3) which was measured.

A result is shown in Table 1.

<Comparative example 1>

By using the anisotropically conductive connector A1 having no lubricant applied thereto in place of the anisotropically conductive connector B1 having the lubricant applied thereto, the repetitive durability was evaluated in the same manner as in the example 1.

A result is shown in the Table 1.

Table 1

| | Application of lubricant | Number of times of measurement at which current resistance value $R_1$ exceeded $1\Omega$ |
|---|---|---|
| Example 1 (anisotropically conductive connector B1) | Yes | 13000 |
| Comparative example 1 (anisotropically conductive connector A1) | No | 7000 |

After these tests were ended, the deformed condition of a conductive path forming part and the migrated condition of an electrode substance to a conductive particle were evaluated in accordance with the following reference for each of the anisotropically conductive connectors B1 and A1. A result is shown in Table 2.

Deformed condition of conductive path forming part:

The surface of the conductive path forming part was observed visually, and the case in which a deformation is rarely generated was evaluated as AA, the case in which a fine deformation is observed was evaluated as BB, and the case in which a large deformation is observed was evaluated as CC. Migrated condition of electrode substance to conductive particle:

The color of the conductive particle in the conductive path forming part was observed visually, and the case in which a discoloration is rarely generated was evaluated as AA, the case in which a slight discoloration to a gray color is generated was evaluated as BB, and the case in which a discoloration to a gray or black color is mostly generated was evaluated as CC.

Table 2

| | Deformed condition of conductive path forming part | Migrated condition of electrode substance to conductive particle |
|---|---|---|
| Example 1 (anisotropically conductive connector B1) | AA | AA |
| Comparative example 1 (anisotropically conductive connector A1) | CC | BB |

**Claims**

1. An anisotropically conductive connector to be used for electrically connecting a circuit board for an inspection having an electrode for an inspection which is provided corresponding to an electrode to be inspected in a circuit device to be an inspection target to the circuit device to be the inspection target,
wherein a lubricant is applied to at least a surface on a side which comes in contact with the circuit device to be the inspection target.

2. The anisotropically conductive connector according to claim 1, wherein the lubricant is a metal salt of alkyl sulfonic acid.

3. A method of inspecting a circuit device which serves to electrically connect an electrode to be inspected in a circuit device to be an inspection target to an inspection electrode of a circuit board for an inspection with an anisotropically conductive connector interposed therebetween, thereby carrying out an electrical inspection,
wherein an anisotropically conductive connector having a lubricant applied to at least a surface on a side which comes in contact with the circuit device to be the inspection target is used to cause a surface on the inspected electrode side of the circuit device to come in contact with the surface of the anisotropically conductive connector to which the lubricant is applied, thereby carrying out an electrical inspection.

4.  The method of inspecting a circuit device according to claim 3, wherein the electrode to be inspected in the circuit device to be the inspection target is a solder projected electrode.

5.  The method of inspecting a circuit device according to claim 3 or 4, wherein the lubricant is a metal salt of alkyl sulfonic acid.

fig.1

fig.2

fig.3

fig.4

71

72

73

B ---·---·---·---·---·---·---·---·---·--- B

fig.5

73

71

fig.6

fig.7

fig.8

fig.9

fig.10

fig.11

fig.12

Pressurization

fig.13

Pressurization

fig.14

fig.15

fig.16

Pressurization

## INTERNATIONAL SEARCH REPORT

| International application No. |
| --- |
| PCT/JP2004/018562 |

**A. CLASSIFICATION OF SUBJECT MATTER**
Int.Cl$^7$ G01R1/06

According to International Patent Classification (IPC) or to both national classification and IPC

**B. FIELDS SEARCHED**

Minimum documentation searched (classification system followed by classification symbols)
Int.Cl$^7$ G01R1/06-1/073, H01R11/01, H01L21/66, G01R31/26

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 6-60390 A (Bridgestone Corp.), 04 March, 1994 (04.03.94), Par No. [0003] (Family: none) | 1-5 |
| A | JP 2000-206149 A (Sony Corp.), 28 July, 2000 (28.07.00), Par Nos. [0028] to [0029]; Fig. 4 (Family: none) | 1-5 |
| A | JP 2001-93599 A (JSR Corp.), 06 April, 2001 (06.04.01), Full text; all drawings (Family: none) | 1-5 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 04 February, 2005 (04.02.05) | 22 February, 2005 (22.02.05) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

**INTERNATIONAL SEARCH REPORT**

International application No.

PCT/JP2004/018562

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-283954 A (JSR Corp.),<br>12 October, 2001 (12.10.01),<br>Full text; all drawings<br>(Family: none) | 1-5 |
| A | JP 2001-237039 A (NEC Corp.),<br>31 August, 2001 (31.08.01),<br>Full text; all drawings<br>& US 2001/0016435 A1 | 1-5 |

Form PCT/ISA/210 (continuation of second sheet) (January 2004)